# EUROPEAN PATENT SPECIFICATION

(11) **EP 3 806 609 B1**
(45) Date of publication and mention of the grant of the patent: **07.06.2023**
(21) Application number: 18921592.4
(22) Date of filing: 05.06.2018
(51) Int. Cl.: H05K 13/02, H05K 13/04

(54) **TAPE FEEDER**
BANDZUFÜHRER
DISTRIBUTEUR DE BANDE

(43) Date of publication of application: 14.04.2021
(73) Proprietor: Fuji Corporation, Chiryu-shi, Aichi 472-8686 (JP)
(72) Inventor: TANAKA, Keita, Chiryu-shi, Aichi 472-8686 (JP); HOSOI, Norio, Chiryu-shi, Aichi 472-8686 (JP); KUNIHIRO, Tsutomu, Chiryu-shi, Aichi 472-8686 (JP); MURASE, Hiroki, Chiryu-shi, Aichi 472-8686 (JP)
(74) Representative: Grünecker Patent- und Rechtsanwälte PartG mbB
(86) International application number: PCT/JP2018/021516
(87) International publication number: WO 2019/234817

(56) References cited:
- EP-A1- 2 773 174
- EP-A1- 2 775 810
- WO-A1-2015/189986
- WO-A1-2016/079785
- JP-A- 2005 347 351
- JP-A- 2013 125 880
- JP-A- 2017 084 862
- JP-A- 2017 135 184
- US-A1- 2015 083 845

## Description

### Technical Field

The present specification discloses a technique related to a tape feeder including a state display section for displaying a state of a tape feeder.

### Background Art

For example, as described in Patent Literature 1 (JP-A-2017-135184), there is a tape feeder in which a state display section for displaying a state (abnormality, normal, close to component shortage, or the like) of the tape feeder is provided on an upper end surface portion of the tape feeder. In general, although a height of the eyes of an operator for monitoring an operation status of the component mounting machine is higher than that of the tape feeder set on a feeder setting base of the component mounting machine, by providing a state display section on the upper end surface portion of the tape feeder is provided, the operator can visually monitor the state of the tape feeder with ease.

Patent Literature 2 to 4 provide further tape feeder according to the prior art.

### Patent Literature

Patent Literature 1: JP-A-2017-135184
Patent Literature 2: US 2015 083845 A1
Patent Literature 3: EP 2773174 A1
Patent Literature 4: EP 2775810 A1

### Summary of the Invention

### Technical Problem

A conventional general tape feeder is configured such that a guide rail for guiding a movement in an attaching and detaching direction is provided on a lower end surface portion thereof so that the lower end surface portion of the tape feeder is adapted to be held by the guide rail on a feeder setting base of a component mounting machine.

On the other hand, since an upper end surface portion side of the tape feeder is not held, there is a possibility that the tape feeder set on the feeder setting base of the component mounting machine is in a slightly inclined state. On the upper end surface portion of the tape feeder, since a component pickup position for picking up a component by a suction nozzle of the component mounting machine is located, positional deviation of the component pickup position occurs in accordance with an inclination of the tape feeder. Since the positional deviation of the component pickup position causes an occurrence of a component suction error, it is desirable to manage a positional deviation amount of the component pickup position to fall within an allowable range.

However, even at an inclination angle which is not a problem in a height dimension of the tape feeder of Patent Literature 1, if the height dimension of the tape feeder becomes large, there is a possibility that the positional deviation amount of the component pickup position is increased and exceeds an allowable range, and thereby an occurrence rate of the component suction error is expected to increase.

As a countermeasure, a configuration is conceivable in which a guide rail for guiding the movement in the attaching and detaching direction is provided on the upper end surface portion of the tape feeder held by a rail holding member provided on an upper side of a feeder accommodation space of the component mounting machine, but in this configuration, there is a problem that a state display section provided on the upper end surface portion of the tape feeder is hidden by the rail holding member on the upper side of the feeder accommodation space of the component mounting machine, thereby cannot being viewed.

### Solution to Problem

The invention is defined by claim 1. Further embodiments are defined in the dependent claims.

To solve the problem described above, in the tape feeder, an upper holding
member, which is held on an upper side of a feeder accommodation space of a component mounting machine, is provided on an upper end surface portion of a feeder body; and a state display section, which displays a state of the tape feeder, is provided on an end surface portion of the feeder body on a removal direction side and a lower holding member configured to be held on a lower side of the feeder accommodation space of the component mounting machine is provided on a lower end surface portion of the feeder body and the upper holding member is a guide rail having a T-shaped cross section configured to guide a movement of the feeder body in an attaching and detaching direction and to prevent the feeder body from coming out downward, and wherein the lower holding member is a guide rail having an I-shaped cross section configured to guide the movement of the feeder body in the attaching and detaching direction without preventing the feeder body from coming out upward.

In this configuration, noticing that the component pickup position is located on the upper end surface portion of the feeder body, the upper holding member, which is held on the upper side of the feeder accommodation space of the component mounting machine, is provided on the upper end surface portion of the feeder body, so that even in a state where a height dimension of the feeder body becomes large, or the feeder body set in the feeder accommodation space of the component mounting machine is inclined, it is possible to further reliably fit, without being affected by that, a positional deviation amount of the component pickup position located on the upper end surface portion of the feeder body within an allowable range by a positioning function of the upper holding member.

Moreover, even if the upper end surface portion of the feeder body is hidden by the member of the feeder accommodation space of the component mounting machine on the upper side thereby cannot being viewed, since the state display section is provided on the end surface portion of the feeder body on the removal direction side, an operator can easily check a state of the tape feeder by easily viewing the state display section without being obstructed by the member of the feeder accommodation space on the upper side.

### Brief Description of Drawings

[Fig. 1] Fig. 1 is a perspective view of a tape feeder of one example in an oblique direction on a removal direction side.
[Fig. 2] Fig. 2 is a side view of the tape feeder.
[Fig. 3] Fig. 3 is a longitudinal front view illustrating an enlarged holding structure, on an upper end surface portion side, of the tape feeder set in a feeder accommodation space of a component mounting machine.
[Fig. 4] Fig. 4 is a partially broken side view illustrating an enlarged clamp structure, on the upper end surface portion side, of the tape feeder set in the feeder accommodation space of the component mounting machine.
[Fig. 5] Fig. 5 is a perspective view illustrating an enlarged state display section provided on the end surface portion of the tape feeder on the removal direction side.
[Fig. 6] Fig. 6 is a block diagram illustrating an electrical configuration of the tape feeder.

### Description of Examples

Hereinafter, one example disclosed in the present description is described by using the drawings. First, an entire configuration of tape feeder 10 will be described.

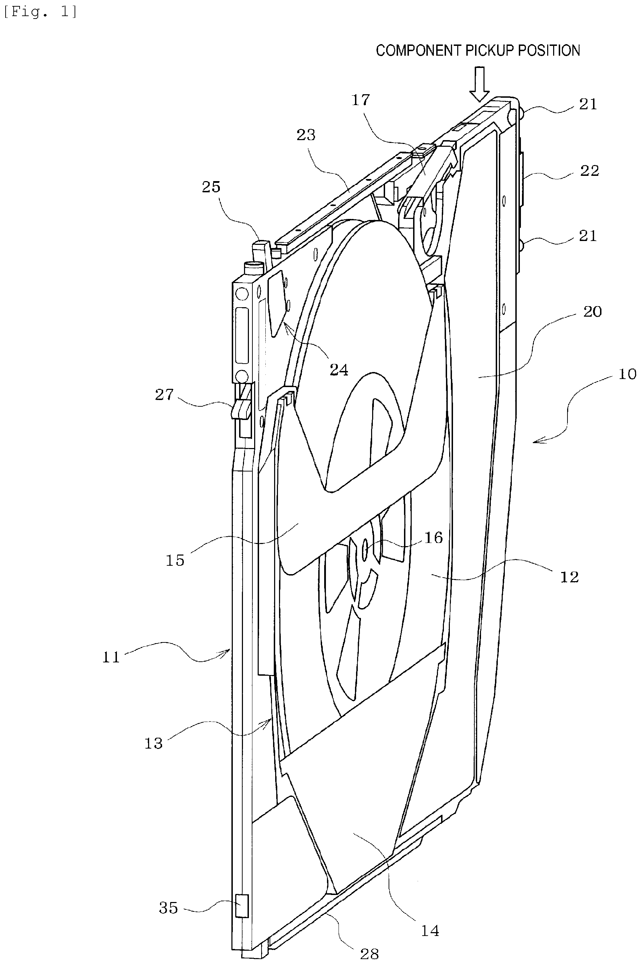

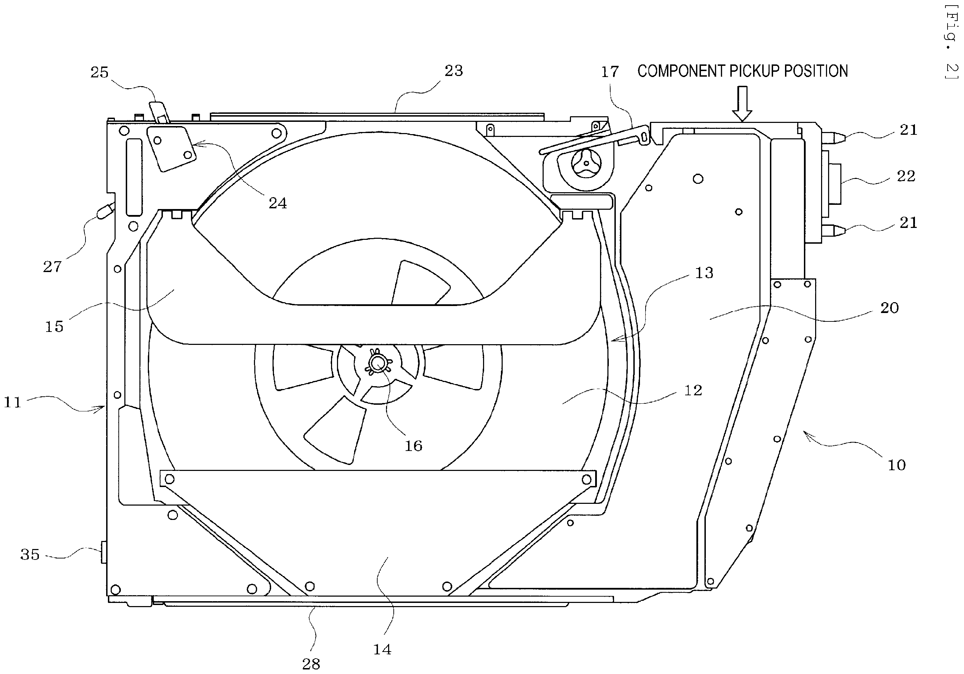

As illustrated in Figs. 1 and 2, within thin box-shaped feeder body 11 of tape feeder 10, reel accommodation space 13, in which tape reel 12 on which a component supply tape (not illustrated) is wound, is exchangeably (detachably) accommodated, is provided. At a lower side portion of reel accommodation space 13, reel cover 14 for covering a lower side portion of tape reel 12 is provided. At an upper portion of reel accommodation space 13, reel presser 15 for holding tape reel 12 set within reel accommodation space 13 in a set state is turnably provided to be opened and closed with both sides of upper end portions thereof as fulcra.

In a case where tape reel 12 is taken out from reel accommodation space 13, by opening an upper side of reel accommodation space 13 by turning reel presser 15 upward with the both sides of the upper end portions thereof as the fulcra, tape reel 12 is extracted obliquely upward while slightly tilting on a front side by gripping, by hand, an upper side of tape reel 12 within reel accommodation space 13. In a case where tape reel 12 is set within reel accommodation space 13, if reel presser 15 is closed by inserting a lower side of tape reel 12 into reel cover 14 from obliquely above within reel accommodation space 13 in which reel presser 15 is opened, the set of tape reel 12 within reel accommodation space 13 is completed.

In this case, another configuration may be provided such that a short shaft (not illustrated) fitted into center hole 16 of tape reel 12 is provided at a center portion of reel accommodation space 13 so that tape reel 12 is rotatably supported by the short shaft. In a case where this configuration is adopted, it is preferable that a length of the shaft is made shorter than a length of center hole 16 of tape reel 12 (for example, 1/2 to 1/3 of the length) such that the shaft fitted into center hole 16 of tape reel 12 does not hinder a detachability of tape reel 12. Alternatively, a configuration may be provided in which multiple rollers (not illustrated) are provided on the lower side of reel accommodation space 13 along an outer periphery of tape reel 12, and the outer periphery of tape reel 12 is rotatably received to be supported by the multiple rollers.

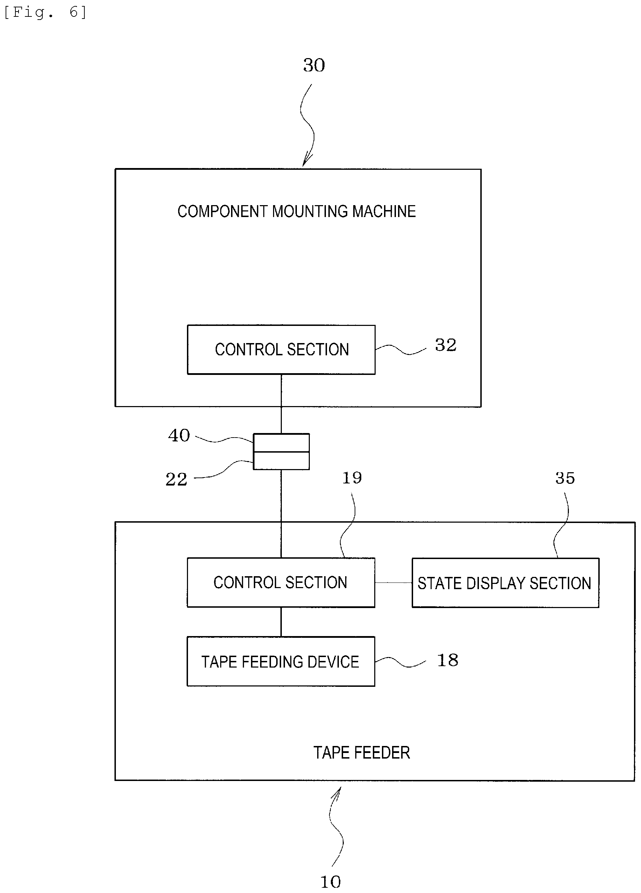

In the upper end surface portion of feeder body 11, a component pickup position for picking up a component by a suction nozzle (not illustrated) of component mounting machine 30 (see Fig. 6) is set at a position close to an end surface portion of feeder body 11 on an attaching direction side. On a lower side of the upper end surface portion of feeder body 11, tape guide 17 for guiding a component supply tape drawn out from tape reel 12 to the component pickup position is provided.

In feeder body 11, a space between reel accommodation space 13 and an end surface portion of feeder body 11 on the attaching direction side has electrical component accommodation space 20. Electrical component accommodation space 20 is provided with various electrical elements such as tape feeding device 18 (see Fig. 6) for pitch-feeding the component supply tape to the component pickup position by drawing out the component supply tape from tape reel 12 within reel accommodation space 13, and control section 19 (see Fig. 6) for controlling the pitch-feeding operation.

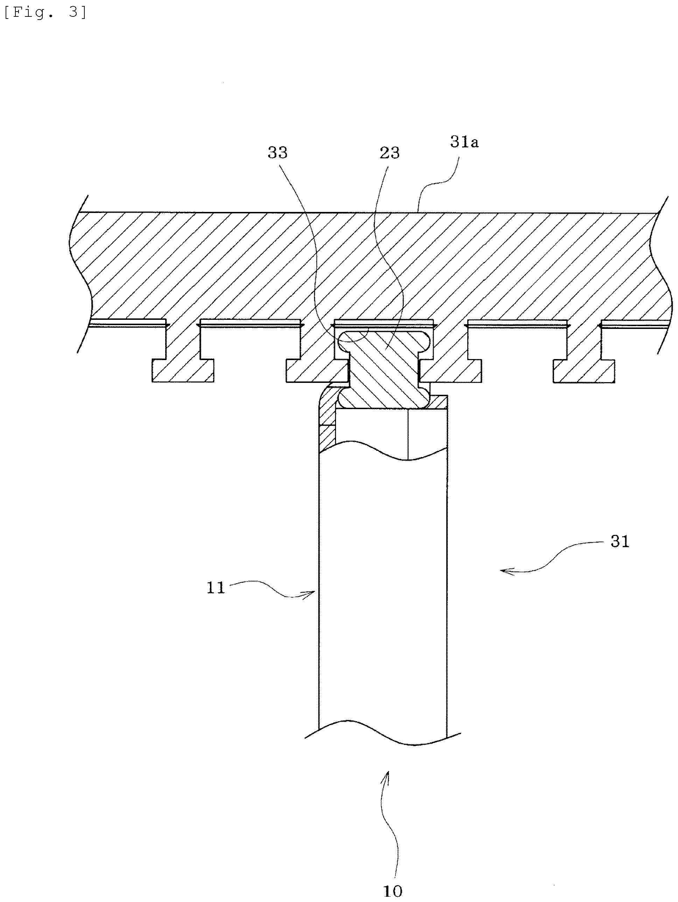

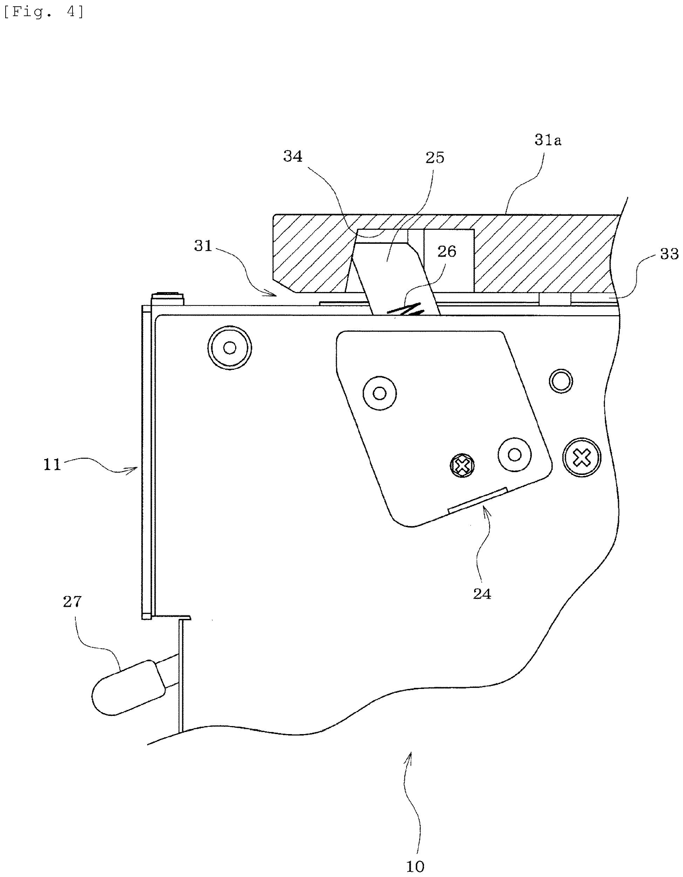

In the end surface portion of feeder body 11 on the attaching direction side, two positioning pins 21 and 21 (positioning section) for positioning with respect to feeder accommodation space 31 (see Figs. 3 and 4) of component mounting machine 30 are provided at predetermined intervals in an upward-downward direction at a position (position close to the upper end surface portion of feeder body 11 in the present example) higher than a center in a height direction. Between these two positioning pins 21 and 21, connector 22 for power supply and communication is provided, and connector 22 of feeder body 11 is inserted and coupled to connector 40 (see Fig. 6) on a component mounting machine 30 side, so that power is supplied to various electrical elements such as tape feeding device 18 and control section 19 within feeder body 11 from component mounting machine 30 side; and various signals such as a control signal and a sensor signal are transmitted and received between control section 32 (see Fig. 6) of component mounting machine 30 and control section 19 of feeder body 11.

Next, a configuration for holding feeder body 11 with respect to feeder accommodation space 31 of component mounting machine 30 in a set state (attached state) will be described.

In the upper end surface portion of feeder body 11, guide rail 23 having a T-shaped cross section is provided, as an upper holding member, at the upper side portion of reel accommodation space 13 such as to extend in an attaching and detaching direction of feeder body 11. Correspondingly, in member 31a of feeder accommodation space 31 of component mounting machine 30 on the upper side, slot groove 33 (see Fig. 3) having a T-shaped cross section, in which guide rail 23 having the T-shaped cross section of feeder body 11 is slidably fitted in the attaching and detaching direction of feeder body 11, is provided so as to extend in the attaching and detaching direction of feeder body 11; and guide rail 23 having the T-shaped cross section of feeder body 11 is fitted into slot groove 33 having the T-shaped cross section of feeder accommodation space 31, so that a sliding movement in the attaching and detaching direction of feeder body 11 is guided and feeder body 11 is held in a state of being prevented from coming out downward. As illustrated in Fig. 3, on the upper side of feeder accommodation space 31, multiple slot grooves 33 are provided at predetermined intervals so that it is possible to set multiple feeder bodies 11 within feeder accommodation space 31.

Further, at the upper end surface portion of feeder body 11, clamp device 24 (see Fig. 4) for clamping feeder body 11 is provided at a position close to the end surface portion of feeder body 11 on the removal direction side, in a state where feeder body 11 is attached to feeder accommodation space 31 of component mounting machine 30. Clamp device 24 includes clamp member 25 which protrudes obliquely upward from the upper end surface portion of feeder body 11 at a time of a clamping operation; spring 26 such as a spring for obliquely biasing clamp member 25 upward in a clamping direction; and operation lever 27 (operation section) for operating a clamp release operation to draw in clamp member 25 obliquely downward that is a clamp release direction. Operation lever 27 is disposed such as to protrude from the end surface portion of feeder body 11 in the removal direction side.

On the other hand, on the upper side of feeder accommodation space 31 of component mounting machine 30, clamp hole 34 (see Fig. 4) is provided at a position corresponding to clamp member 25, and clamp member 25 is fitted into clamp hole 34 so that feeder body 11 is adapted to be clamped in an attached state. In this case, as illustrated in Fig. 4, clamp member 25 is pushed obliquely upward feeder body 11 on of the removal direction side by spring 26, pressing the upper end portion of clamp member 25 against a side surface of feeder body 11 of clamp hole 34 on the removal direction side; which turns out feeder body 11 being pressed by a reaction on the attaching direction side; feeder body 11 is accurately positioned; and a connection state of connectors 22 and 40 is adapted to be held.

As illustrated in Figs. 1 and 2, the lower end surface portion of feeder body 11 is provided with guide rail 28 having an I-shaped cross section as a lower holding member such as to extend in the attaching and detaching direction of feeder body 11. Correspondingly, a member (not illustrated) of feeder accommodation space 31 of component mounting machine 30 on the lower side is provided with a rail groove (not illustrated) having an I-shaped cross section to which guide rail 28 having the I-shaped cross section of feeder body 11 is slidably fitted in the attaching and detaching direction of feeder body 11; and guide rail 28 having the I-shaped cross section of feeder body 11 is fitted to the rail groove having the I-shaped cross section of feeder accommodation space 31, so that a sliding movement of feeder body 11 in the attaching and detaching direction is guided and feeder body 11 is held in a state of not being prevented from coming out upward. Thus, even if a manufacturing variation of the height dimension of feeder accommodation space 31 of component mounting machine 30 and a manufacturing variation of the height dimension of feeder body 11 are slightly increased, a frictional resistance force is prevented from being increased at a time of the sliding movement of feeder body 11 in the attaching and detaching direction; and the attachment and detachment of feeder body 11 can be smoothly performed.

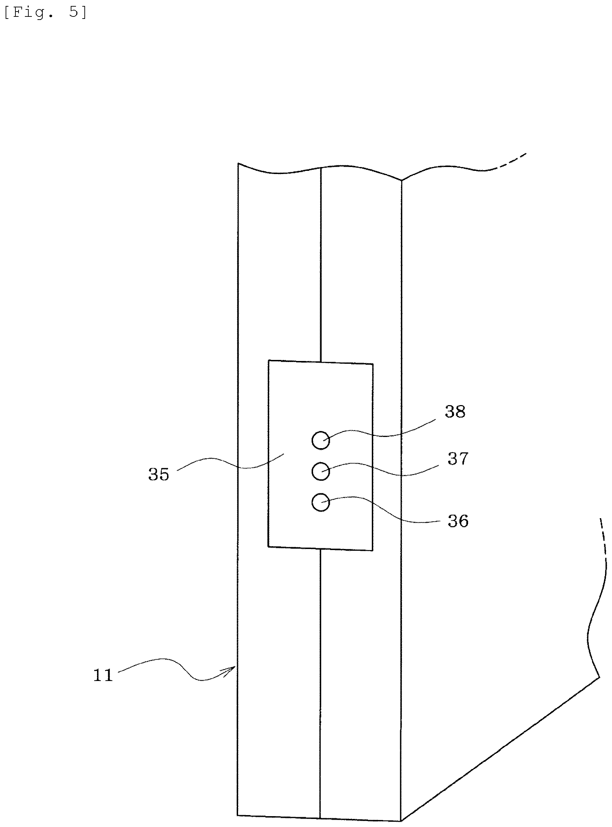

As illustrated in Figs. 1 and 2, in an end surface portion of feeder body 11 on the removal direction side, state display section 35 for displaying the state of tape feeder 10 is provided at a position lower than the center in the height direction thereof. In the present example, as illustrated in Fig. 5, state display section 35 includes multiple light emitting elements 36, 37, and 38, for example, three LEDs having different emitting colors, and these three light emitting elements 36, 37, and 38 are arranged in a vertically one line.

Here, in light emitting element 36 at a lowermost position, the light emitting color is blue, and when tape feeder 10 is normally operated, light emitting element 36 at the lowermost position emits blue light so that it is displayed that the operation of tape feeder 10 is normal (no abnormality). In light emitting element 37 at an intermediate position, the light emitting color is yellow, and when the component remaining number of the component supply tape being wound on tape reel 12 is equal to or less than a predetermined value, light emitting element 37 at the intermediate position emits yellow light so that it is displayed that the component remaining number is equal to or less than the predetermined value (close to component shortage). Alternatively, light emitting element 37 at the intermediate position emits yellow light at the timing of the component shortage, so that component being in a shortage stage is displayed. In light emitting element 38 at an uppermost position, the light emitting color is red, and when the abnormality of the component supply action (tape feeding operation) occurs, light emitting element 38 at the uppermost position emits red light so that the abnormal (error) state of the operation of tape feeder 10 is displayed.

Others, when control section 19 of tape feeder 10 or control section 32 of component mounting machine 30 determines a need of the maintenance of tape feeder 10 based on an occurrence rate or the like of a component suction error, it may be provided a light emitting element for displaying it. Alternatively, a light emitting element may be provided to display the power when the power is supplied to tape feeder 10.

The attachment and detachment of tape feeder 10 configured as described above to and from feeder accommodation space 31 of component mounting machine 30 may be automatically performed by an automatic exchanging device (not illustrated) or may be manually performed by an operator.

In the tape feeder described in Patent Literature 1 described above, since the tape reel is accommodated in the reel holder provided on the outside of the feeder body, it is possible to reduce a height dimension of the feeder body smaller than a diameter of the tape reel.

However, since tape feeder 10 of the present example has the configuration of the tape reel accommodation type for accommodating tape reel 12 within feeder body 11, the height dimension of feeder body 11 is larger than the diameter of tape reel 12. Therefore, as in Patent Literature 1, if tape feeder 10 of the tape reel accommodation type in the present example employs a configuration for holding only on the lower end surface portion side, even at the inclination angle of the feeder body which is not a problem in the height dimension of the tape feeder of Patent Literature 1, in a case where the height dimension of feeder body 11 becomes large, there is a possibility that the positional deviation amount of the component pickup position is increased and exceeds an allowable range, and thereby an occurrence rate of the component suction error is expected to increase.

Therefore, tape feeder 10 of the present example is provided with guide rail 23 having the T-shaped cross section for guiding the movement in the attaching and detaching direction at the upper end surface portion of feeder body 11 so that the upper end surface portion of feeder body 11 is held on the upper side of feeder accommodation space 31 of component mounting machine 30. In this configuration, even if the height dimension of feeder body 11 becomes large or feeder body 11 set in feeder accommodation space 31 of component mounting machine 30 is in the inclined state, it is possible to further reliably fit, without being affected by that, a positional deviation amount of the component pickup position located on the upper end surface portion of feeder body 11 within an allowable range by a positioning function of guide rail 23 having the T-shaped cross section. Therefore, it is possible to reduce the occurrence of the component suction error caused by the positional deviation of the component pickup position, and it is possible to reduce the occurrence rate of the component suction error.

Moreover, even if the upper end surface portion of feeder body 11 is hidden by member 31a of feeder accommodation space 31 of component mounting machine 30 on the upper side thereby cannot being viewed, since state display section 35 is provided on the end surface portion of feeder body 11 on the removal direction side, the operator can easily check the state of tape feeder 10 by easily viewing state display section 35 without being obstructed by member 31a of feeder accommodation space 31 of component mounting machine 30 on the upper side.

Furthermore, in the present example, on the end surface portion of feeder body 11 on the attaching direction side, positioning pins 21 and 21 for positioning with respect to feeder accommodation space 31 of component mounting machine 30 are provided at a position higher than the center in the height direction, so that the upper end surface portion of feeder body 11 can be positioned by positioning pins 21 and 21 in the vicinity of the component pickup position, and there is an advantage that can further reduce the positional deviation amount of the component pickup position.

Moreover, in the present example, clamp device 24 for clamping feeder body 11 to feeder accommodation space 31 of component mounting machine 30 is provided on the upper end surface portion of feeder body 11 in a state where feeder body 11 is attached to feeder accommodation space 31 of component mounting machine 30, so that the upper end surface portion of feeder body 11 can be set in a state of being accurately positioned with respect to the upper side of feeder accommodation space 31 of component mounting machine 30 by the positioning effect of guide rail 23 having the T-shaped cross section provided on the upper end surface portion of feeder body 11 and by the clamp effect of clamp device 24.

Further, taking into consideration that operation lever 27 for operating the clamp release operation of clamp device 24 is provided on the upper side of the end surface portion of feeder body 11 on the removal direction side, state display section 35 for displaying the state of tape feeder 10 is provided at a position lower than the center in the height direction in the end surface portion of feeder body 11 on the removal direction side, so that the operator can easily check the state of tape feeder 10 by easily viewing state display section 35 without being obstructed by operation lever 27.

Furthermore, the configuration of state display section 35 is not limited to the above-described example, and the emitting color, the number, and the arrangement of the light emitting elements may be changed. Alternatively, the state display section may be configured by a digital display or the like, and the state of tape feeder 10 may be displayed by characters or symbols such as numerals or alphabetic characters. In this case, a relationship between characters and symbols such as numerals and alphabetic characters, and the state of tape feeder 10 may be defined in advance.

### Reference Signs List

10... tape feeder, 11... feeder body, 12... tape reel, 13... reel accommodation space, 15... reel presser, 18... tape feeding device, 19... control section of tape feeder, 21... positioning pin (positioning section), 22... connector, 23... guide rail (upper holding member), 24... clamp device, 25... clamp member, 26... spring, 27... operation lever (operation section), 28... guide rail (lower holding member), 30... component mounting machine, 31... feeder accommodation space, 32... control section of component mounting machine, 33... slot groove, 34... clamp hole, 35... state display section, 36, 37, 38... light emitting element

## Claims

1. A tape feeder (10) comprising:
an upper holding member (23) provided on an upper end surface portion of a feeder body (11) and configured to be held on an upper side of a feeder accommodation space (31) of a component mounting machine (30); and
a state display section (35), being provided on an end surface portion of the feeder body (11) on a removal direction side, which is configured to display a state of the tape feeder (10)
a lower holding (28) member configured to be held on a lower side of the feeder accommodation space (31) of the component mounting machine (30) is provided on a lower end surface portion of the feeder body (11)
the upper holding member (23) is a guide rail (23) having a T-shaped cross section configured to guide a movement of the feeder body (11) in an attaching and detaching direction and to prevent the feeder body (11) from coming out downward, and **characterised in that**
the lower holding member (28) is a guide rail (28) having an I-shaped cross section configured to guide the movement of the feeder body (11) in the attaching and detaching direction without preventing the feeder body (11) from coming out upward.

2. The tape feeder (10) according to claim 1, wherein
in an end surface portion of the feeder body (11) on an attaching direction side, a positioning section (21) for positioning the feeder body (11) with respect to the feeder accommodation space (31) of the component mounting machine (30) is provided at a position higher than a center in a height direction thereof.

3. The tape feeder (10) according to claim 1 or 2, wherein
a tape reel (12) on which a component supply tape is wound is accommodated within the feeder body (11).

4. The tape feeder (10) according to any one of claims 1 to 3, wherein
a clamp device (24) configured to clamp the feeder body (11) to the feeder accommodation space (31) of the component mounting machine (30) is provided on the upper end surface portion of the feeder body (11) in a state where the feeder body (11) is attached to the feeder accommodation space (31) of the component mounting machine (30).

5. The tape feeder (10) according to claim 4, wherein
an operation section (27) configured to operate a clamp release operation of the clamp device (24) is provided on the end surface portion of the feeder body (11) on the removal direction side.

6. The tape feeder (10) according to any one of claims 1 to 5, wherein
the state display section (35) is provided at a position lower than a center in a height direction in the end surface portion of the feeder body (11) on the removal direction side.

7. The tape feeder (10) according to any one of claims 1 to 6, wherein
the state display section (35) displays an abnormality in a component supply action when the component supply action is abnormal, a component shortage when the component shortage occurs, or a component remaining number when the component remaining number is equal to or less than a predetermined value.

## Patentansprüche

1. Ein Bandzuführer (10) umfassend:
ein oberes Halteelement (23), das an einem oberen Endflächenabschnitt eines Zuführkörpers (11) angeordnet und konfiguriert ist an einer Oberseite eines Zuführaufnahmeraums (31) einer Bauteilmontagemaschine (30) gehalten zu werden; und
einen Zustandsanzeigeabschnitt (35), der an einem Endflächenabschnitt des Zuführkörpers (11) an einer Entnahmerichtungsseite angeordnet ist, der konfiguriert ist einen Zustand des Bandzuführers (10) anzuzeigen
ein unteres Halteelement (28), das konfiguriert ist an einer unteren Seite des Zuführaufnahmeraums (31) der Bauteilmontagemaschine (30) gehalten zu werden, ist an einem unteren Endoberflächenabschnitt des Zuführkörpers (11) angeordnet, wobei
das obere Halteelement (23) eine Führungsschiene (23) mit einem T-förmigen Querschnitt ist, die konfiguriert ist eine Bewegung des Zuführkörpers (11) in einer Anbringungs- und Ablöserichtung zu führen und zu verhindern, dass der Zuführkörper (11) nach unten herauskommt, und
**gekennzeichnet dadurch, dass:**
das untere Halteelement (28) eine Führungsschiene (28) mit einem I-förmigen Querschnitt ist, die konfiguriert ist die Bewegung des Zuführkörpers (11) in der Anbringungs- und Ablöserichtung zu führen, ohne zu verhindern, dass der Zuführkörper (11) nach oben herauskommt.

2. Der Bandzuführer (10) gemäß Anspruch 1, wobei
in einem Endflächenabschnitt des Zuführkörpers (11) auf der Seite der Anbringungsrichtung ein Positionierungsabschnitt (21) zum Positionieren des Zuführkörpers (11) in Bezug auf den Zuführaufnahmeraum (31) der Bauteilmontagemaschine (30) an einer Position angeordnet ist, die höher als eine Mitte in einer Höhenrichtung davon ist.

3. Der Bandzuführer (10) gemäß Anspruch 1 oder 2, wobei
eine Bandspule (12), auf die ein Bauteilzuführband aufgewickelt ist, im Zuführkörper (11) untergebracht ist.

4. Der Bandzuführer (10) gemäß einem der Ansprüche 1 bis 3, wobei
eine Klemmvorrichtung (24), die konfiguriert ist den Zuführkörper (11) an den Zuführaufnahmeraum (31) der Bauteilmontagemaschine (30) zu klemmen, an dem oberen Endflächenabschnitt des Zuführkörpers (11) in einem Zustand angeordnet ist, in dem der Zuführkörper (11) an dem Zuführaufnahmeraum (31) der Bauteilmontagemaschine (30) angebracht ist.

5. Der Bandzuführer (10) gemäß Anspruch 4, wobei
ein Betätigungsabschnitt (27), der konfiguriert ist einen Klemmlösungsvorgang der Klemmvorrichtung (24) zu betätigen, ist an dem Endflächenabschnitt des Zuführkörpers (11) an der Entnahmerichtungsseite angeordnet.

6. Der Bandzuführer (10) gemäß einem der Ansprüche 1 bis 5, wobei
der Zustandsanzeigeabschnitt (35) an einer Position unterhalb einer Mitte in einer Höhenrichtung in dem Endflächenabschnitt des Zuführkörpers (11) auf der Entnahmerichtungsseite angeordnet ist.

7. Der Bandzuführer (10) gemäß einem der Ansprüche 1 bis 6, wobei
der Zustandsanzeigeabschnitt (35) eine Anomalie in einer Bauteilzuführaktion, wenn die Bauteilzuführaktion anomal ist, einen Bauteildefizit, wenn der Bauteildefizit auftritt, oder eine Bauteilrestanzahl anzeigt, wenn die Bauteilrestanzahl gleich oder kleiner als ein vorbestimmter Wert ist.

## Revendications

1. Distributeur à bande (10) comprenant :
un élément supérieur de support (23) disposé sur la surface terminale supérieure du corps d'un distributeur (11) et configuré pour être maintenu sur le côté supérieur d'un espace d'accueil de distributeur (31) d'une machine de montage de composants (30), et
une section d'affichage d'état (35) disposée sur une partie de surface terminale du corps de distributeur (11) sur le côté de la direction d'élimination, laquelle est configurée pour afficher l'état du distributeur à bande (10),
un élément inférieur de support (28), configuré pour être maintenu sur le côté inférieur de l'espace d'accueil de distributeur (31) de la machine de montage de composants (30), est disposé sur la surface terminale inférieure du corps de distributeur (11),
l'élément supérieur de support (23) est un rail de guidage (23) présentant une section transversale en forme de T, configuré pour guider le mouvement du corps de distributeur (11) dans un sens de fixation et de démontage et empêcher le corps de distributeur (11) de s'échapper vers le bas, et **caractérisé en ce que** :
l'élément inférieur de support (28) est un rail de guidage (28) présentant une section transversale en forme de I, configuré pour guider le mouvement du corps de distributeur (11) dans le sens de fixation et de démontage sans empêcher le corps de distributeur (11) de s'échapper vers le haut.

2. Distributeur à bande (10) selon la revendication 1, dans lequel :
sur une partie de surface terminale du corps de distributeur (11) du côté du sens de fixation, il est prévu une section de positionnement (21) destinée à positionner le corps de distributeur (11) par rapport à l'espace d'accueil de distributeur (31) de la machine de montage de composants (30), à une position supérieure au centre dans sa direction de la hauteur.

3. Distributeur à bande (10) selon la revendication 1 ou la revendication 2, dans lequel :
une bobine de bande (12), sur laquelle est bobinée une bande de délivrance de composants, est logée à l'intérieur du corps de distributeur (11).

4. Distributeur à bande (10) selon l'une quelconque des revendications 1 à 3, dans lequel :
un dispositif de serrage (24), configuré pour immobiliser le corps de distributeur (11) sur l'espace d'accueil de distributeur (31) de la machine de montage de composants (30), est disposé sur une partie de surface terminale supérieure du corps de distributeur (11) de sorte à ce que le corps de distributeur (11) soit fixé sur l'espace d'accueil de distributeur (31) de la machine de montage de composants (30).

5. Distributeur à bande (10) selon la revendication 4, dans lequel :
une section de manoeuvre (27), configurée pour réaliser une opération de libération de bride du dispositif de serrage (24), est disposée sur la partie de surface terminale du corps de distributeur (11) du côté de la direction de l'élimination.

6. Distributeur à bande (10) selon l'une quelconque des revendications 1 à 5, dans lequel :
la section d'affichage d'état (35) est disposée à une position inférieure au centre dans la direction de la hauteur dans la partie de surface terminale du corps de distributeur (11) du côté de la direction de l'élimination.

7. Distributeur à bande (10) selon l'une quelconque des revendications 1 à 6, dans lequel :
la section d'affichage d'état (35) affiche une anomalie dans une action de délivrance de composant lorsque l'action de délivrance de composant est anormale, un manque de composants lorsqu'il se produit un manque de composants, ou bien un nombre de composants restants lorsque le nombre des composants restants est inférieur ou égal à une valeur prédéterminée.
